(19) Europäisches Patentamt / European Patent Office / Office européen des brevets

(11) **EP 3 816 762 B1**

(12) **EUROPÄISCHE PATENTSCHRIFT**

(45) Veröffentlichungstag und Bekanntmachung des Hinweises auf die Patenterteilung:
**20.12.2023 Patentblatt 2023/51**

(21) Anmeldenummer: **19206267.7**

(22) Anmeldetag: **30.10.2019**

(51) Internationale Patentklassifikation (IPC):
**G06F 1/02** *(2006.01)*          **H03K 4/02** *(2006.01)*

(52) Gemeinsame Patentklassifikation (CPC):
**G06F 1/022**

(54) **SIGNALGENERATOR**

SIGNAL GENERATOR

GÉNÉRATEUR DE SIGNAL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**05.05.2021 Patentblatt 2021/18**

(73) Patentinhaber: **Carl Zeiss Industrielle Messtechnik GmbH
73447 Oberkochen (DE)**

(72) Erfinder:
• **Gruber, Udo
91799 Langenaltheim (DE)**
• **Maier, Thomas
73431 Aalen (DE)**

(74) Vertreter: **Altmann Stößel Dick Patentanwälte PartG mbB
Theodor-Heuss-Anlage 2
68165 Mannheim (DE)**

(56) Entgegenhaltungen:
**DE-C1- 3 613 505          DE-C1- 19 906 559
US-A1- 2011 006 817**

• **Anonymous: "Bhaskara I's sine approximation formula - Wikipedia", , 27. September 2019 (2019-09-27), XP055690728, Gefunden im Internet:
URL:https://en.wikipedia.org/w/index.php?title=Bhaskara_I's_sine_approximation_formula&oldid=918152432 [gefunden am 2020-04-30]**

**Beschreibung**

Gebiet der Erfindung

Die Erfindung betrifft einen Signalgenerator, ein System zu einem Erzeugen mindestens eines Ausgangssignals und ein Verfahren zum Erzeugen mindestens eines periodischen Ausgangssignals. Die vorliegende Erfindung betrifft insbesondere das Gebiet der integrierten Schaltkreise.

Technischer Hintergrund

Aus dem Stand der Technik sind grundsätzlich Verfahren und Vorrichtungen zu einem Erzeugen eines periodischen Ausgangssignals bekannt. Beispielsweise können Mikrocontroller oder Integrierte Schaltkreise verwendet werden.

Das Erzeugen von periodischen Ausgangssignalen kann dabei mit einer festeingestellten Amplitude und Frequenz des Ausgangssignals erfolgen. Weiter sind Funktionengeneratoren bekannt, bei welchen Änderungen von Amplitude und/oder Frequenz möglich sind. Derartige Generatoren benötigten jedoch eine hohe Rechenleistung und viel Ressourcen. Bisher bekannte Funktionsgeneratoren waren nur sehr schwer in einem FPGA umsetzbar, da die Berechnung der Signale sehr aufwendig und Ressourcen aufwändig ist.

DE 36 13 505 beschreibt einen digitalen Frequenz-Synthesizer zum Erzeugen einer Dreieckspannung, bei dem in einem Addierer gesteuert durch einen Taktgenerator Zahleninkremente in aufeinanderfolgenden Teilperioden abwechselnd addiert bzw. subtrahiert werden. Zwischen dem Taktgenerator und dem Addierer ist ein Schalter angeordnet, der über einen am Ausgang des Addierers angeschalteten binaren Komparator bei Erreichen eines vorbestimmten Zahlenwertes den Taktgenerator vom Addierer abschaltet.

Aufgabe der Erfindung

Es ist daher Aufgabe der vorliegenden Erfindung, einen Signalgenerator, ein System zu einem Erzeugen mindestens eines Ausgangssignals und ein Verfahren zum Erzeugen mindestens eines periodischen Ausgangssignals bereitzustellen, welche die Nachteile bekannter Vorrichtungen und Verfahren zumindest weitgehend vermeiden. Insbesondere soll eine Einstellung von Amplitude und Frequenz ressourcenschonend ermöglicht werden.

Offenbarung der Erfindung

Diese Aufgabe wird gelöst durch Vorrichtungen und ein Verfahren mit den Merkmalen der unabhängigen Patentansprüche. Vorteilhafte Weiterbildungen, welche einzeln oder in Kombination realisierbar sind, sind in den abhängigen Ansprüchen dargestellt.

Im Folgenden werden die Begriffe "haben", "aufweisen", "umfassen" oder "einschließen" oder beliebige grammatikalische Abweichungen davon in nicht-ausschließlicher Weise verwendet. Dementsprechend können sich diese Begriffe sowohl auf Situationen beziehen, in welchen, neben dem durch diese Begriffe eingeführten Merkmal, keine weiteren Merkmale vorhanden sind, oder auf Situationen, in welchen ein oder mehrere weitere Merkmale vorhanden sind. Beispielsweise kann sich der Ausdruck "A hat B", "A weist B auf", "A umfasst B" oder "A schließt B ein" sowohl auf die Situation beziehen, in welcher, abgesehen von B, kein weiteres Element in A vorhanden ist (d.h. auf eine Situation, in welcher A ausschließlich aus B besteht), als auch auf die Situation, in welcher, zusätzlich zu B, ein oder mehrere weitere Elemente in A vorhanden sind, beispielsweise Element C, Elemente C und D oder sogar weitere Elemente.

Weiterhin wird darauf hingewiesen, dass die Begriffe "mindestens ein" und "ein oder mehrere" sowie grammatikalische Abwandlungen dieser Begriffe oder ähnliche Begriffe, wenn diese in Zusammenhang mit einem oder mehreren Elementen oder Merkmalen verwendet werden und ausdrücken sollen, dass das Element oder Merkmal einfach oder mehrfach vorgesehen sein kann, in der Regel lediglich einmalig verwendet werden, beispielsweise bei der erstmaligen Einführung des Merkmals oder Elementes. Bei einer nachfolgenden erneuten Erwähnung des Merkmals oder Elementes wird der entsprechende Begriff "mindestens ein" oder "ein oder mehrere" in der Regel nicht mehr verwendet, ohne Einschränkung der Möglichkeit, dass das Merkmal oder Element einfach oder mehrfach vorgesehen sein kann.

Weiterhin werden im Folgenden die Begriffe "vorzugsweise", "insbesondere", "beispielsweise" oder ähnliche Begriffe in Verbindung mit optionalen Merkmalen verwendet, ohne dass alternative Ausführungsformen hierdurch beschränkt werden. So sind Merkmale, welche durch diese Begriffe eingeleitet werden, optionale Merkmale, und es ist nicht beabsichtigt, durch diese Merkmale den Schutzumfang der Ansprüche und insbesondere der unabhängigen Ansprüche einzuschränken. So kann die Erfindung, wie der Fachmann erkennen wird, auch unter Verwendung anderer Ausgestaltungen durchgeführt werden. In ähnlicher Weise werden Merkmale, welche durch "in einer Ausführungsform der Erfindung" oder durch "in einem Ausführungsbeispiel der Erfindung" eingeleitet werden, als optionale Merkmale verstanden, ohne dass hierdurch alternative Ausgestaltungen oder der Schutzumfang der unabhängigen Ansprüche eingeschränkt werden soll. Weiterhin sollen durch diese einleitenden Ausdrücke sämtliche Möglichkeiten, die hierdurch eingeleiteten Merkmale mit anderen Merkmalen zu kombinieren, seien es optionale oder nicht-optionale Merkmale, unangetastet bleiben.

In einem ersten Aspekt der vorliegenden Erfindung wird ein Signalgenerator vorgeschlagen. Der Begriff "Signalgenerator", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf eine Vorrichtung zum Erzeugen eines grundsätzlich beliebigen Ausgangssignals beziehen. Der Begriff "Ausgangssignal", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf eine elektrische Spannung beziehen. Das Ausgangssignal kann eine Frequenz und eine Amplitude aufweisen.

Der Signalgenerator ist eingerichtet, mindestens ein periodisches Ausgangssignal zu erzeugen. Das Ausgangssignal umfasst ein Dreiecksignal. Eine Frequenz und Amplitude des Ausgangssignals sind einstellbar. Der Signalgenerator ist eingerichtet, um mindestens einen Eingangsparameter zu empfangen. Der Eingangsparameter umfasst mindestens eine Information über eine Soll-Amplitude und eine Soll-Frequenz des Ausgangssignals. Der Signalgenerator weist mindestens eine Verarbeitungseinheit auf. Die Verarbeitungseinheit ist eingerichtet, um eine Signalrichtung des Ausgangssignals zu bestimmen. Die Verarbeitungseinheit ist eingerichtet, um eine Schrittweite zu bestimmen. Die Verarbeitungseinheit ist eingerichtet, um eine Ist-Amplitude in Abhängigkeit der Signalrichtung für eine Anzahl an Takten mit der Schrittweite zu beaufschlagen. Die Anzahl an Takten ist abhängig von der Soll-Frequenz des Ausgangssignals.

Der Begriff "periodisches Ausgangssignal", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf ein sich zeitlich wiederholendes Ausgangssignal beziehen. Unter einem "Dreiecksignal" kann eine Dreieckschwingung verstanden werden. Das Dreiecksignal kann einen charakteristischen Zeitverlauf aufweisen. Beispielsweise kann das Dreiecksignal bis zu einem Maximum linear ansteigen und dann linear bis zu einem Minimum abfallen. Auch andere Zeitverläufe sind denkbar. Beispielsweise kann das Dreieckssignal zunächst bis zum Minimum abfallen und dann linear bis zum Maximum ansteigen. Das Dreiecksignal kann eine Mehrzahl von Wiederholungen aufweisen, insbesondere periodischen Wiederholungen.

Der Begriff "einstellbar", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf ein Ändern und/oder ein Anpassen der Frequenz und Amplitude beziehen. Die Frequenz und Amplitude können auf eine Soll-Frequenz und Soll-Amplitude eingestellt werden. Die Begriffe "Soll-Frequenz" und "Soll-Amplitude", wie sie hier verwendet werden, sind weite Begriffe, denen ihre gewöhnliche und gängige Bedeutung beigemessen werden soll, wie der Fachmann sie versteht. Die Begriffe sind nicht beschränkt auf eine spezielle oder angepasste Bedeutung. Die Begriffe können, ohne Beschränkung, sich insbesondere auf eine gewünschte Frequenz und eine gewünschte Amplitude beziehen. Beispielsweise kann der Signalgenerator ein Ausgangssignal mit einer Ist-Frequenz und Ist-Amplitude erzeugen und die Frequenz und Amplitude auf die Soll-Frequenz und Soll-Amplitude eingestellt werden. Die Ist-Frequenz und die Ist-Amplitude können aktuelle Werte von Frequenz und Amplitude sein. Die Soll-Frequenz und Ist-Frequenz können $\geq 0$ sein

Der Begriff "Eingangsparameter", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf mindestens einen Eingangswert und/oder mindestens eine Eingangsgröße beziehen, in deren Abhängigkeit das Ausgangssignal erzeugt wird. Der Eingangsparameter kann beispielsweise ein Wert einer Variablen sein. Der Eingangsparameter kann ein vorverarbeiteter Eingangsparameter sein, welcher in mindestens einem Vorverarbeitungsschritt erzeugt wurde. Der Eingangsparameter umfasst mindestens eine Information über eine Soll-Amplitude und eine Soll-Frequenz des Ausgangssignals. Die Information über die Soll-Amplitude und die Soll-Frequenz kann Werte für Soll-Amplitude und Soll-Frequenz umfassen und/oder weitere Größen, welche aus diesen bestimmt wurden.

Der Signalgenerator kann mindestens eine Schnittstelle umfassen, welche eingerichtet ist, die Information über die Soll-Amplitude und die Soll-Frequenz zu empfangen. Der Begriff "empfangen", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf ein Eingeben der Information beispielsweise über eine Mensch-Maschine-Schnittstelle wie beispielsweise eine Eingabe-/Ausgabe-Vorrichtung wie ein Display und/oder eine Tastatur beziehen und/oder einen Datentransfer unter Verwendung mindestens einer Kommunikationsschnittstelle. Der Signalgenerator kann beispielsweise mindestens eine Kommunikationsschnittstelle umfassen, welche eingerichtet ist, mindestens eine Verbindung, insbesondere eine LAN- oder SPI-Verbindung, zu einer weiteren Rechnereinheit bereitzustellen und einen Datentransfer der Information von der Rechnereinheit zu dem Signalgenerator zu ermöglichen.

Der Signalgenerator weist mindestens eine Verarbeitungseinheit auf. Der Begriff "Verarbeitungseinheit", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf eine Datenverarbeitungsvorrichtung beziehen, welche eingerichtet ist, die Information über Soll-Amplitude und Soll-Frequenz auszuwerten und ein Ausgangssignal zu bestimmen. Die Verarbeitungseinheit kann mindestens einen Mikrocontroller, mindestens ein Field Programmable Gate Array (FPGA) oder mindestens einen Prozessor aufweisen.

Die Verarbeitungseinheit ist eingerichtet, um eine Signalrichtung des Ausgangssignals zu bestimmen. Der Begriff "Signalrichtung", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf einen zeitlichen Verlauf des Ausgangssignals beziehen. Die Signalrichtung kann eine Zählrichtung sein. Die Signalrichtung kann positiv oder negativ sein. Eine positive Signalrichtung kann eine Signalrichtung sein, bei welcher das Signal von einem Startpunkt, beispielsweise einem Minimum oder Achsennullpunkt, zu einem Maximum verläuft. Eine negative Signalrichtung kann eine Signalrichtung sein, bei welcher das Signal von einem Startpunkt, beispielsweise einem Maximum oder Achsennullpunkt, zu einem Minimum verläuft. Der Begriff "Bestimmen der Signalrichtung", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf ein Festlegen einer Signalrichtung beziehen, beispielsweise in Abhängigkeit von einem bisherigen Signalverlauf.

Der Signalgenerator kann eingerichtet sein, das Dreiecksignal durch Addieren oder Subtrahieren eines konstanten Werts auf einen aktuellen Wert für eine bestimmte Anzahl an Takten zu bestimmen. Somit kann immer die gleiche Zeit nach unten und die gleiche Zeit nach oben gezählt werden.

Die Verarbeitungseinheit ist eingerichtet eine Schrittweite zu bestimmen. Der Begriff "Schrittweite", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf eine charakteristische Größe beziehen, welche den Wert pro Takt des Signalgenerators angibt, der auf die Ist-Amplitude zum Erreichen der Soll-Amplitude zu addieren oder zu subtrahieren ist. Die Schrittweite kann ≥ 0 sein. Die Schrittweite kann vorbestimmt sein, insbesondere dem Signalgenerator gegeben werden. Die Schrittweite kann beispielsweise von einer Datenvorverarbeitung vorbestimmt sein und/oder kann eingegeben werden.

Die Verarbeitungseinheit kann eingerichtet sein, um ein Dreiecksignal zu bestimmen. Die Verarbeitungseinheit kann eingerichtet sein, um zum Bestimmen des Dreiecksignals die folgenden Schritte auszuführen:

a) Bestimmen einer Startvariable n0, wobei abhängig von der Signalrichtung das Bestimmen ein Addieren oder Subtrahieren einer Schrittweite von einem Startwert umfasst, mit n0 = n0 + (Schrittweite*Signalrichtung), wobei die Schrittweite abhängig von der Soll-Amplitude und der Soll-Frequenz des Ausgangssignals ist,
b) Begrenzen der in a) bestimmten Startvariable;
c) Speichern der begrenzten Startvariable als Dreiecksignal.

Die Verarbeitungseinheit kann eingerichtet sein, nach Schritt c) die Signalrichtung des Ausgangssignals anzupassen, insbesondere erneut.

Der Begriff "Startvariable", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf einen Startwert einer grundsätzlich beliebigen Variablen beziehen. Die Startvariable n0 kann ≥ 0 oder ≤ 0 sein. Die Startvariable kann ein beliebiger positiver oder negativer Integer sein.

Der Begriff "Takt", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf eine Zeiteinheit beziehen, insbesondere einer internen Uhr des Signalgenerators, mit welcher dieser arbeitet. Der Takt kann von mindestens einem Taktgenerator erzeugt werden. Periodische Signale haben vier Sektoren, auch als Signal-Sektoren bezeichnet, auf einem Einheitskreis. Eine Anzahl Takte pro Sektor, welche für die Soll-Frequenz "freq" benötigt wird, kann durch

$$TakteproSektor = \frac{TaktFrequenz}{freq*4}$$

bestimmt werden, wobei "TaktFrequenz" die Taktfrequenz des Signalgenerators ist. Unter einer "Taktfrequenz" kann eine Zahl von Impulsen pro Sekunde verstanden werden. Beispielsweise kann der Signalgenerator einen FPGA umfassen. Beispielsweise kann die Taktfrequenz 20 kHz sein.

$$Schrittweite = \frac{amp}{TakteProsektor}$$

Die Schrittweite kann als $$Schrittweite = \frac{amp}{TakteProsektor}$$ bestimmt werden, wobei amp eine Amplitude des zu erzeugenden Ausgangssignals ist. Bei Verwendung eines FPGA als Signalgenerator kann die Schrittweite $$Schrittweite = \frac{amp*256}{TakteProsektor}$$ sein. Der FPGA kann eingerichtet sein, das Ausgangssignal um den Faktor 256 größer zu berechnen. Dies erlaubt Nachkommastellen zu berücksichtigen, welches üblicherweise mit einem FPGA nicht möglich ist. Das Ausgangssignal kann so viel größer berechnet werden, als es eigentlich ist, so dass die Nachkommastellen in die Ganz-Zahlen hineinrutschen. Der Faktor 256 berücksichtigt, dass der FPGA das Ausgangssignal skaliert um 256 berechnet.

Der Begriff "Begrenzen der Startvariablen", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf ein Einschränken auf die Soll-Amplitude, insbesondere auf ein positives Maximum oder ein negatives Minimum, beziehen. Die Verarbeitungseinheit kann eingerichtet sein, um in Schritt b) eine skalierte Amplitude n1 mit n1 = amp *nscale zu bestimmen, wobei amp die Soll-Amplitude und nscale ein Skalierungsfaktor ist, und die bestimmte Startvariable auf die skalierte Amplitude zu begrenzen. Bei Verwendung eines FPGAs als Signalgenerator kann nscale beispielsweise 256 sein, welches einem links-shift um 8 Bits entspricht. Bei einem Links-shiften um ein Bit kann der Wert mit dem Faktor 2 multipliziert werden. Dies kann, wie oben beschrieben, erlauben, Nachkommastellen zu berücksichtigen.

Das Dreiecksignal kann aus der Schrittweite und der Signalrichtung durch Ausführen eines Programmcodes erzeugt werden, insbesondere eines Programmcodes in der Programmiersprache C oder ein VHDL-Code. Die Verarbeitungseinheit kann eingerichtet sein, den Programmcode auszuführen.

Beispielsweise kann der Programmcode zum Erzeugen des Dreiecksignals mit einem FPGA folgendermaßen ausgestaltet sein:

$$n = Schrittweite*Signalrichtung; \qquad (1)$$
$$n0 = n0 + n; \qquad (2)$$
$$n1 = amp*256; \qquad (3)$$
$$n0 = lim(n0,n1); \qquad (4)$$
$$dreieck = n0 >> 8; \qquad (5)$$
$$n2 = lim\_sts(dreieck, amp); \qquad (6)$$
$$if (n2 !=0)\{ \qquad (7)$$
$$SignalRichtung = SignalRichtung * (-1); \qquad (8)$$
$$\} \qquad (9)$$

In Zeilen (1) und (6) bis (9) wird die Signalrichtung festgelegt. Die Funktion "lim_sts" in Zeile 6 gibt eine 1 zurück, wenn die Variable "dreieck" die positive Soll-Amplitude "amp" nach oben überschreitet, eine -1 wird zurückgegeben, wenn die Variable "dreieck" die negative Soll-Amplitude nach unten unterschreitet, und eine 0 wird zurückgegeben, wenn sich der Wert der Variablen "dreieck" innerhalb der negativen und der positiven Soll-Amplitude "amp"befindet. Bei erreichter positiver und bei erreichter negativer Soll-Amplitude soll die Signalrichtung umgekehrt werden. Zeile (2) bewirkt abhängig von der Variablen "Signal-Richtung" ein Addieren oder Subtrahieren der Schrittweite. Die Variable "Schrittweite" kann in einer Daten-Vorverarbeitung bestimmt werden. Zeile (3) multipliziert die Soll-Amplitude mit dem Faktor 256, was einem links-shift um 8 bit entspricht. In Zeile (4) wird der Wert der Variablen "n0" auf die maximale Soll-Amplitude, positiv oder negativ, welche mit einem Faktor 256 multipliziert wurde (Variable "n1"), begrenzt. Das Dreiecksignal mit der Soll-Amplitude wird in Zeile (5) erzeugt. Das Dreiecksignal wird aus der Variablen "n0" erzeugt, welche durch den Faktor 256 dividiert wird, was einem rechts-shift um 8 bit entspricht. Bei einem Rechts-shiften um ein Bit kann ein Wert durch den Faktor 2 dividiert werden.

Die Verarbeitungseinheit ist eingerichtet, um eine Ist-Amplitude in Abhängigkeit der Signalrichtung für eine Anzahl an Takten mit der Schrittweite zu beaufschlagen. Die Anzahl an Takten ist abhängig von der Soll-Frequenz des Ausgangssignals. Insbesondere kann die Schrittweite aus der Anzahl an Takten bestimmt sein oder werden. Die Verarbeitungseinheit kann eingerichtet sein, um die Schrittweite in Abhängigkeit der Signalrichtung auf die Ist-Amplitude des Ausgangssignals zu addieren oder von der Ist-Amplitude zu subtrahieren.

Der Signalgenerator kann weiterhin eingerichtet sein, mindestens ein Rechtecksignal zu erzeugen. Der Begriff "Rechtecksignal", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf ein periodisches Signal beziehen, welches zwischen zwei im Wesentlich konstanten Werten hin und her schaltet. Unter "im Wesentlichen konstanten Wert" kann verstanden werden, dass Abweichungen von einer Konstanten von $\leq 5\%$, bevorzugt von $\leq 1\%$ möglich sind. Das Rechtecksignal kann insbesondere gleichzeitig mit dem Dreiecksignal erzeugt werden. Aus dem Dreiecksignal kann zusätzlich das Rechtecksignal erzeugt werden. Wenn das Dreiecksignal nach oben zählt, kann die positive komplette eingestellte Amplitude ausgegeben werden, und wenn das Dreiecksignal nach unten zählt, kann die negative komplette Amplitude ausgegeben werden. Die Verarbeitungseinheit kann eingerichtet sein, um das Rechtecksignal aus der Signalrichtung und der Soll-Amplitude zu bestimmen.. Zum Erzeugen des Rechtecksignals kann die Verarbeitungseinheit eingerichtet sein, einen Programmcode auszuführen. Insbesondere kann zum Erzeugen des Rechtecksignals der Programmcode zusätzlich zu dem oben beschriebenen Programmcode weitere Schritte aufweisen. Beispielsweise kann zum Bestimmen des Rechtecksignals eine weitere Zeile zwischen den Zeilen (5) und (6) eingefügt werden:

$$rechteck = SignalRichtung*amp;$$

Durch diese zusätzliche Zeile kann beim Zählen in positive Richtung beim Dreiecksignal die maximale positive Amplitude und beim Zählen in negative Richtung beim Dreiecksignal die maximale negative gewünschte Amplitude in der Variablen "rechteck" gespeichert werden.

Der Signalgenerator kann weiterhin eingerichtet sein, mindestens ein Sinus-Signal zu erzeugen. Der Begriff "Sinus-Signal", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf ein periodisches Signal beziehen, welches im Wesentlichen Sinus-förmig ist. Unter "im Wesentlichen Sinus-förmig" kann verstanden werden, dass Abweichungen von einer Sinusfunktion von $\leq 5\%$, bevorzugt von $\leq 1\%$ möglich sind. Das Sinus-Signal kann insbesondere gleichzeitig mit dem Dreiecksignal erzeugt werden. Die Berechnung eines echten Sinus-Signals kann sehr aufwändig sein. Insbesondere müsste für jeden einzelnen Wert eine Reihen-Entwicklung ausgeführt werden. Der Signalgenerator kann eingerichtet sein, das Sinus-Signal durch quadratische Funktionen anzunähern. Die Verarbeitungseinheit kann eingerichtet sein, um das Sinus-Signal durch Quadrieren und Skalieren des Dreiecksignals zu bestimmen und zu erzeugen. Zum Erzeugen des Sinus-Signals kann die Verarbeitungseinheit eingerichtet sein, einen Programmcode auszuführen. Insbesondere kann zum Erzeugen des Sinus-Signals der Programmcode zusätzlich zu dem oben beschriebenen Programmcode weitere Schritte aufweisen. Beispielsweise kann zum Bestimmen und Erzeugen des Sinus-Signals mehrere weitere Zeilen zwischen den Zeilen (5) und (6) eingefügt werden:

$$sinus\_1 = dreieck*dreieck;$$

$$sinus\_2 = sinus\_1*SinusKoeffizient;$$

$$sinus\_3 = sinus\_2 >>16;$$

$$sinus\_4 = amp - sinus\_3;$$

$$sinus\_5 = sinus\_4*SignalRichtung;$$

Zunächst wird nach diesem Programmcode das Dreiecksignal quadriert, so dass ein Signal mit nach oben geöffneten Parabeln entsteht. Anschließend wird das Signal durch Multiplikation mit der Variablen "SinusKoeffizient" und rechts-shiften um 16 bit skaliert. Die Variable "SinusKoeffizient" kann in einer Daten-Vorverarbeitung bestimmt werden. Die Form des Signals kann unverändert bleiben. Der Sinuskoeffizient kann für ein FPGA durch Si-

6

$$nuskoeffzient = \frac{65535}{amp}$$ bestimmt werden, wobei amp die Sollamplitude ist. Die Zahl 65535 =256*256 berücksichtigt das Quadrieren des Dreiecksignals. In der Programmcodezeile für die Bestimmung der Variable "sinus_4" können die Parabeln horizontal gespiegelt werden. In der letzten Zeile des Programmcodes wird das Sinus-Signal mit Soll-Amplitude und Soll-Frequenz erzeugt.

Beispielsweise kann der Programmcode zum gleichzeitigen Erzeugen eines Drecksignals, eines Rechtecksignals und eines Sinus-Signals mit einem FPGA folgendermaßen ausgestaltet sein:

$$n = Schrittweite*Signalrichtung;$$
$$n0 = n0 + n;$$
$$n1 = amp*256;$$
$$n0 = lim(n0,n1);$$
$$dreieck = n0 >> 8;$$
$$sinus\_1 = dreieck*dreieck;$$
$$sinus\_2 = sinus\_1*SinusKoeffizient;$$
$$sinus\_3 = sinus\_2 >> 16;$$
$$sinus\_4 = amp - sinus\_3;$$
$$sinus\_5 = sinus\_4*SignalRichtung;$$
$$rechteck = SignalRichtung*amp;$$
$$n2 = lim\_sts(dreieck, amp);$$
$$if (n2 != 0)\{$$
$$SignalRichtung = SignalRichtung * (-1);$$
$$\}$$

Der erfindungsgemäße Signalgenerator erlaubt eine gleichzeitige Erzeugung und Zurverfügungstellung von drei periodischen Ausgangssignalen. Diese kann dadurch erreicht werden, dass die einzelnen Signale aufeinander aufbauend generiert werden. Der Programmcode kann in der Verarbeitungseinheit ausgeführt werden, insbesondere innerhalb des FPGAs. Der Programmcode kann zudem nur Berechnungen umfassen, welche für einen FPGA nicht aufwendig sind, wie Multiplikation, Bitshiften, Addieren und logische Verknüpfungen, so dass der Programmcode ressourcenschonend ist. Für einen FPGA aufwändige Operationen, wie Divisionen und Berechnung von Komma-Zahlen, können auf externen Recheneinheiten berechnet werden, welche diese Operationen mit viel weniger Ressourcen-Aufwand ausführen können. Weiter kann der Signalgenerator ein Sinus-Signal durch quadratische Funktionen nachbilden, so dass viel Rechenleistung gespart werden kann. Ein Erzeugen von Ausgangssignalen ist so auch mit sehr kleinen FPGAs möglich, welche sehr viel günstiger sind als große FPGAs. Bisher bekannte Funktionsgeneratoren waren nur sehr schwer in einem FPGA umsetzbar, da die Berechnung der Signale sehr aufwendig und Ressourcen aufwändig ist. Der erfindungsgemäße Signalgenerator kann darauf optimiert sein, dass er sehr gut und ressourcenschonend in einem FPGA umsetzbar ist durch Dividieren nur durch Bitshiften und sonst lediglich Multiplikationen, Additionen und Subtraktionen. Es ist jedoch auch denkbar, dass der Signalgenerator auch in einem Micro-Controller berechnet wird.

In einem weiteren Aspekt der vorliegenden Erfindung wird ein System zu einem Erzeugen mindestens eines Ausgangssignals vorgeschlagen. Der Begriff "System", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf eine Vorrichtung umfassend mindestens zwei Elemente beziehen, welche insbesondere funktionell zusammenwirken. Das System kann ein Hardware-System sein. Das System umfasst mindestens einen erfindungsgemäßen Signalgenerator. Für Einzelheiten und Ausführungsformen in Bezug auf das System wird auf die Beschreibung des erfindungsgemäßen Signalgenerators verwiesen.

Das System weist mindestens eine Recheneinheit auf. Der Begriff "Recheneinheit", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf eine Vorrichtung zur Datenverarbeitung beziehen, beispielsweise einen MicroController, einen PC, oder einen Laptop. Wie oben ausgeführt, kann der Signalgenerator mindestens einen FPGA umfassen. Ein FPGA kann ausschließlich Integer-Werte, auch als Ganz-Zahlen bezeichnet, also Zahlen ohne Komma-Werte, berechnen. Eine weitere Schwierigkeit bei einem FPGA kann das Dividieren durch beliebige Zahlen sein, welches viele Ressourcen verbraucht. Viel ressourcenschonender sind Bitshiften und Multiplizieren. Erfindungsgemäß wird deshalb vorgeschlagen, aufwändige Operationen auf eine externe Recheneinheit auszulagern und nur ressourcenschonende Operationen auf der Verarbeitungseinheit des Signalgenerators, insbesondere dem FPGA, zu belassen. Parametrisierungsdaten können so von der externen Recheneinheit vorverarbeitet werden und die vorverarbeiteten Informationen an den Signalgenerator übermittelt werden.

Das System weist mindestens ein Kommunikationsinterface auf. Der Begriff "Kommunikationsinterface", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf eine Schnittstelle beziehen, welche zum Übertragen von Informationen eingerichtet ist. Insbesondere kann das Kommunikationsinterface zum Übertragen von Informationen von einer Recheneinheit, z.B. einem Computer, um Informationen zu senden oder auszugeben, z.B. auf ein anderes Gerät, eingerichtet sein. Zusätzlich oder alternativ kann das Kommunikationsinterface zum Übertragen von Informationen auf eine Rechenvorrichtung konfiguriert sein, z.B. auf einen Computer, um beispielsweise Informationen zu erhalten. Das Kommunikationsinterface kann speziell Mittel zum Übertragen oder Austauschen von Informationen bereitstellen. Insbesondere kann das Kommunikationsinterface eine Datenübertragungsverbindung bereitstellen, z.B. Bluetooth, NFC, induktive Kopplung oder dergleichen. Das Kommunikationsinterface kann beispielsweise eine LAN-Verbindung oder eine SPI-Verbindung bereitstellen. Die mindestens eine Information über die Soll-Amplitude und die Soll-Frequenz des Ausgangssignals ist in das Kommunikationsinterface eingebbar. Die Recheneinheit ist eingerichtet, die eingegebene Information über die Soll-Amplitude und die Soll-Frequenz vorzuverarbeiten und an den Signalgenerator zu übertragen. Die Recheneinheit kann beispielsweise mindestens einen Anwender-Rechner umfassen. Der Anwender kann eine Soll-Frequenz in Hz und eine Soll-Amplitude in Integer Inkrementen in den Anwender-Rechner eingeben. Die Datenvorverarbeitung kann auf dem Anwender-Rechner erfolgen und/oder die Recheneinheit kann eine weitere Recheneinheit aufweisen, welche zu einer Datenvorverarbeitung eingerichtet ist.

Die Vorverarbeitung der eingegebenen Information kann ein Bestimmen mindestens eines Eingangsparameters für den Signalgenerator umfassen. Der Eingangsparameter kann eine Taktfrequenz pro Signal-Sektor sein. Die Recheneinheit kann eingerichtet sein, die Taktfrequenz pro Signal-Sektor durch

$$TakteproSektor = \frac{TaktFrequenzFPGA}{freq*4}$$

zu bestimmen, wobei TaktFrequenzFPGA eine vorbestimmte Taktfrequenz des Signalgenerators und freq eine Frequenz des zu erzeugenden Ausgangssignals ist. Der Eingangsparameter kann alternativ oder zusätzlich eine Schrittweite sein. Die Recheneinheit kann eingerichtet sein, die Schrittweite durch

$$Schrittweite = \frac{amp}{TakteProsektor}$$

zu bestimmen, wobei amp eine Amplitude des zu erzeugenden Ausgangssignals ist. Alternativ oder zusätzlich kann der Eingangsparameter ein Sinuskoeffizient sein. Insbesondere für den Fall eines FPGAs als Signalgenerator kann die Recheneinheit eingerichtet sein, um den Sinuskoeffizienten durch Sinuskoeffizient

$$= \frac{65535}{amp}$$

zu bestimmen, wobei amp eine Amplitude des zu erzeugenden Ausgangssignals ist.

Das System kann mindestens eine Rechnerumgebung aufweisen. Die Rechnerumgebung kann mindestens einen Mikrocontroller, mindestens ein Field Programmable Gate Array (FPGA) oder mindestens einen Prozessor eines Computers aufweisen. Der Signalgenerator kann zumindest teilweise in der Rechnerumgebung implementiert sein.

In einem weiteren Aspekt der vorliegenden Erfindung wird ein Verfahren zum Erzeugen mindestens eines periodischen Ausgangssignals mit mindestens einem erfindungsgemäßen Signalgenerator vorgeschlagen. Das Ausgangssignal umfasst ein Dreiecksignal. Das Verfahren umfasst ein Einstellen einer Frequenz und einer Amplitude des Ausgangssignals.

Das Verfahren umfasst die folgenden Schritte:

i) Empfangen mindestens eines Eingangsparameters, wobei der Eingangsparameter mindestens eine Information über eine Soll-Amplitude und eine Soll-Frequenz des Ausgangssignals umfasst,

ii) Bestimmen einer Signalrichtung des Ausgangssignals mit mindestens einer Verarbeitungseinheit ;

iii) Bestimmen einer Schrittweite mit der Verarbeitungseinheit und Beaufschlagen einer Ist-Amplitude in Abhängigkeit der Signalrichtung für eine Anzahl an Takten mit der Schrittweite, wobei die Anzahl an Takten abhängig von der Soll-Frequenz des Ausgangssignals ist.

Die Verfahrensschritte können in der angegebenen Reihenfolge durchgeführt werden, wobei einer oder mehrere der Schritte zumindest teilweise auch gleichzeitig durchgeführt werden können und wobei einer oder mehrere der Schritte mehrfach wiederholt werden können. Darüber hinaus können weitere Schritte unabhängig davon, ob sie in der vorliegenden Anmeldung erwähnt werden oder nicht, zusätzlich ausgeführt werden. Für Einzelheiten und Ausführungsformen in Bezug auf das Verfahren wird auf die Beschreibung des erfindungsgemäßen Signalgenerators und des erfindungsgemäßen Systems verwiesen.

Das Verfahren zum Bestimmen des Dreiecksignals kann weiter die folgenden Schritte aufweisen:

iv) Bestimmen einer Startvariable n0, wobei abhängig von der Signalrichtung das Bestimmen ein Addieren oder Subtrahieren einer Schrittweite von einem Startwert umfasst, mit n0 = n0 + (Schrittweite*Signalrichtung), wobei die Schrittweite abhängig von der Soll-Amplitude und der Soll-Frequenz des Ausgangssignals ist,

v) Begrenzen der in iv) bestimmten Startvariable;

vi) Speichern der begrenzten Startvariable als Dreiecksignal.

In Schritt v) kann eine skalierte Amplitude n1 mit n1 = amp *nscale bestimmt werden, wobei amp die Soll-Amplitude und nscale ein Skalierungsfaktor ist, und die bestimmte Startvariable auf die skalierte Amplitude begrenzt wird. Nach Schritt vi) kann die Signalrichtung des Ausgangssignals angepasst werden.

Das Verfahren kann ein Erzeugen mindestens eines Rechtecksignals umfassen, insbesondere gleichzeitig mit dem Dreiecksignal. Das Rechtecksignal kann aus der Signalrichtung und der Soll-Amplitude bestimmt werden.

Das Verfahren kann ein Erzeugen mindestens eines Sinus-Signals umfassen, insbesondere gleichzeitig mit dem Dreiecksignal. Das Sinus-Signal kann durch Quadrieren und Skalieren des Dreiecksignals bestimmt und erzeugt werden.

Das Verfahren kann mindestens einen Vorverarbeitungsschritt aufweisen, in welchem der mindestens eine Eingangsparameter, insbesondere ein Mehrzahl von Eingangsparametern, bereitgestellt wird.

Ferner wird im Rahmen der vorliegenden Erfindung ein Computerprogramm vorgeschlagen, das bei Ablauf auf einem Computer oder Computer-Netzwerk, beispielsweise einer Cloud, das erfindungsgemäße Verfahren in einer seiner Ausgestaltungen ausführt, insbesondere die Verfahrensschritte i) bis iii). Weiterhin wird im Rahmen der vorliegenden Erfindung ein Computerprogramm mit Programmcode-Mitteln vorgeschlagen, um das erfindungsgemäße Verfahren in einer seiner Ausgestaltungen durchzuführen, wenn das Programm auf einem Computer oder Computer-Netzwerk ausgeführt wird. Insbesondere können die Programmcode-Mittel auf einem computerlesbaren Datenträger gespeichert sein. Außerdem wird im Rahmen der vorliegenden Erfindung ein Datenträger vorgeschlagen, auf dem eine Datenstruktur gespeichert ist, die nach einem Laden in einen Arbeits- und/oder Hauptspeicher eines Computers oder Computer-Netzwerkes das erfindungsgemäße Verfahren in einer seiner Ausgestaltungen ausführen kann. Auch wird im Rahmen der vorliegenden Erfindung ein Computerprogramm-Produkt mit auf einem maschinenlesbaren Träger gespeicherten Programmcode-Mitteln vorgeschlagen, um das erfindungsgemäße Verfahren in einer seiner Ausgestaltungen durchzuführen, wenn das Programm auf einem Computer oder Computer-Netzwerk ausgeführt wird. Dabei wird unter einem Computer-Programmprodukt das Programm als handelbares Produkt verstanden. Es kann grundsätzlich in beliebiger Form vorliegen, so zum Beispiel auf Papier oder einem computerlesbaren Datenträger, und kann insbesondere über ein Datenübertragungsnetz verteilt werden. Beispielsweise kann die Auswertung des entstehenden und/oder entstandenen Bildmaterials als Web-Service verfügbar sein, beispielsweise über eine gesicherte Verbindung zu herstellerseitigen Servern. Dieses kann vorteilhaft sein, wenn vor Ort keine ausreichenden Rechner-Ressourcen vorgehalten werden können. Schließlich wird im Rahmen der vorliegenden Erfindung ein moduliertes Datensignal vorgeschlagen, welches von einem Computersystem oder Computernetzwerk ausführbare Instruktionen zum Ausführen eines Verfahrens nach einer der beschriebenen Ausführungsformen enthält.

In einem weiteren Aspekt der vorliegenden Erfindung wird eine Verwendung eines erfindungsgemäßen Signalgenerators in einer Rechnerumgebung vorgeschlagen. Die Rechnerumgebung weist einen Mikrocontroller, mindestens einen Integrierten Schaltkreis, insbesondere ein Field Programmable Gate Array (FPGA), oder einen Prozessor eines Computers auf.

Kurze Beschreibung der Figuren

Weitere Einzelheiten und Merkmale ergeben sich aus der nachfolgenden Beschreibung von Ausführungsbeispielen, insbesondere in Verbindung mit den Unteransprüchen. Hierbei können die jeweiligen Merkmale für sich alleine oder zu mehreren in Kombination miteinander verwirklicht sein. Die Erfindung ist nicht auf die Ausführungsbeispiele beschränkt. Die Ausführungsbeispiele sind in den Figuren schematisch dargestellt. Gleiche Bezugsziffern in den einzelnen Figuren bezeichnen dabei gleiche oder funktionsgleiche bzw. hinsichtlich ihrer Funktionen einander entsprechende Elemente.

Im Einzelnen zeigen:

Figur 1 zwei Ausführungsformen eines erfindungsgemäßen Systems;

Figur 2 ein Beispiel eines erzeugten Dreiecksignals;

Figuren 3A und 3B ein weiteres Beispiel eines erzeugten Dreiecksignals und daraus erzeugten Rechtecksignals; und

Figuren 4A bis 4D ein Beispiel einer Erzeugung eines Sinussignals.

Beschreibung der Ausführungsbeispiele

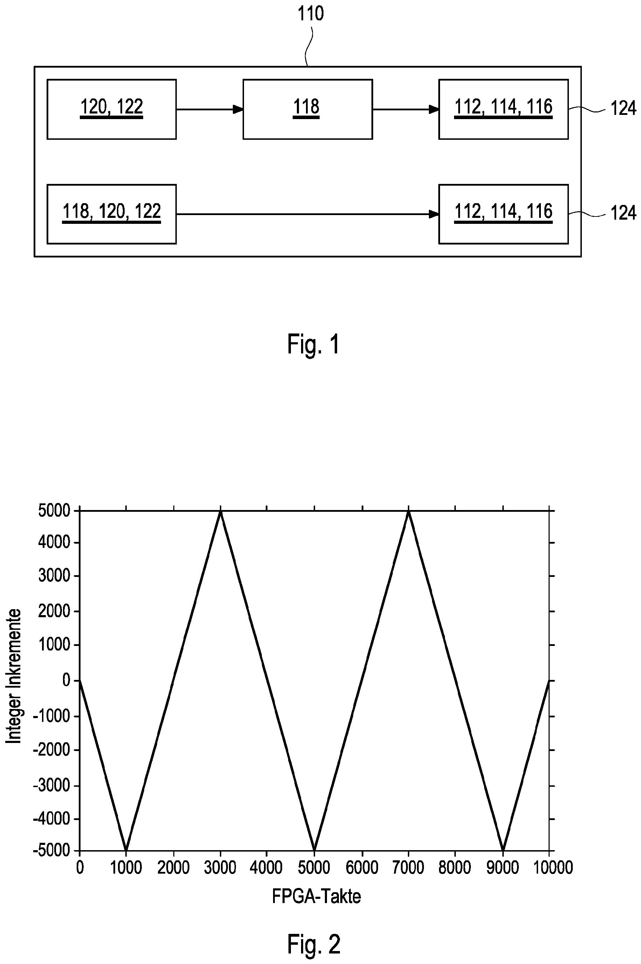

Figur 1 zeigt eine schematische Darstellung eines erfindungsgemäßen Systems 110 zu einem Erzeugen mindestens eines Ausgangssignals. Das System 110 kann ein Hardware-System sein. Das System 110 umfasst mindestens einen erfindungsgemäßen Signalgenerator 112.

Das Ausgangssignal kann eine elektrische Spannung sein. Das Ausgangssignal kann eine Frequenz und eine Amplitude aufweisen. Der Signalgenerator 112 ist eingerichtet, mindestens ein periodisches Ausgangssignal zu erzeugen. Das Ausgangssignal umfasst ein Dreiecksignal. Das Dreiecksignal kann einen charakteristischen Zeitverlauf aufweisen. Beispielsweise kann das Dreiecksignal bis zu einem Maximum linear ansteigen und dann linear bis zu einem Minimum abfallen. Auch andere Zeitverläufe sind denkbar. Beispielsweise kann das Dreieckssignal zunächst bis zum Minimum abfallen und dann linear bis zum Maximum ansteigen. Das Dreiecksignal kann eine Mehrzahl von Wiederholungen aufweisen, insbesondere periodischen Wiederholungen.

Eine Frequenz und Amplitude des Ausgangssignals sind einstellbar. Die Frequenz und Amplitude können auf eine Soll-Frequenz und Soll-Amplitude eingestellt werden. Beispielsweise kann der Signalgenerator ein Ausgangssignal mit einer Ist-Frequenz und Ist-Amplitude erzeugen und die Frequenz und Amplitude auf die Soll-Frequenz und SollAmplitude eingestellt werden. Die Ist-Frequenz und die Ist-Amplitude können aktuelle Werte von Frequenz und Amplitude sein.

Der Signalgenerator 112 ist eingerichtet, um mindestens einen Eingangsparameter zu empfangen. Der Eingangsparameter umfasst mindestens eine Information über eine SollAmplitude und eine Soll-Frequenz des Ausgangssignals. Der Eingangsparameter kann beispielsweise ein Wert einer Variablen sein. Der Eingangsparameter kann ein vorverarbeiteter Eingangsparameter sein, welcher in mindestens einem Vorverarbeitungsschritt erzeugt wurde. Der Eingangsparameter umfasst mindestens eine Information über eine SollAmplitude und eine Soll-Frequenz des Ausgangssignals. Die Information über die SollAmplitude und die Soll-Frequenz kann Werte für Soll-Amplitude und Soll-Frequenz umfassen und/oder weitere Größen, welche aus diesen bestimmt wurden.

Der Signalgenerator 112 kann mindestens eine Schnittstelle 114 umfassen, welche eingerichtet ist, die Information über die Soll-Amplitude und die Soll-Frequenz zu empfangen. Die Schnittstelle 114 kann eingerichtet sein zu einem Eingeben der Information beispielsweise über eine Mensch-Maschine-Schnittstelle wie beispielsweise eine Eingabe-/AusgabeVorrichtung wie ein Display und/oder eine Tastatur und/oder einen Datentransfer unter Verwendung mindestens einer Kommunikationsschnittstelle. Der Signalgenerator 112 kann beispielsweise mindestens eine Kommunikationsschnittstelle umfassen, welche eingerichtet ist, mindestens eine Verbindung, insbesondere eine LAN- oder SPI-Verbindung, zu einer weiteren Rechnereinheit bereitzustellen und einen Datentransfer der Information von der Rechnereinheit zu dem Signalgenerator 112 zu ermöglichen.

Der Signalgenerator 112 weist mindestens eine Verarbeitungseinheit 116 auf. Die Verarbeitungseinheit 116 ist dazu eingerichtet, die Information über Soll-Amplitude und Soll-Frequenz auszuwerten und ein Ausgangssignal zu bestimmen. Die Verarbeitungseinheit 116 kann mindestens einen Mikrocontroller, mindestens ein Field Programmable Gate Array (FPGA) oder mindestens einen Prozessor aufweisen. Die Verarbeitungseinheit 116 kann auch nur ein FPGA sein. Der Micro-Controller kann die Nummer 118 und der mindestens eine Prozessor kann die Nummer 122 sein

Die Verarbeitungseinheit 116 ist eingerichtet, um eine Signalrichtung des Ausgangssignals zu bestimmen. Die Signalrichtung kann eine Zählrichtung sein. Die Signalrichtung kann positiv oder negativ sein. Eine positive Signalrichtung kann eine Signalrichtung sein, bei welcher das Signal von einem Startpunkt, beispielsweise einem Minimum oder Achsennullpunkt, zu einem Maximum verläuft. Eine negative Signalrichtung kann eine Signalrichtung sein, bei welcher das Signal von einem Startpunkt, beispielsweise einem Maximum oder Achsennullpunkt, zu einem Minimum verläuft.

Die Verarbeitungseinheit 116 ist eingerichtet, um eine Schrittweite zu bestimmen. Die Verarbeitungseinheit 116 ist eingerichtet, um eine Ist-Amplitude in Abhängigkeit der Signalrichtung für eine Anzahl an Takten mit der Schrittweite zu beaufschlagen. Die Anzahl an Takten ist abhängig von der Soll-Frequenz des Ausgangssignals. Der Signalgenerator 112 kann eingerichtet sein, das Dreiecksignal durch Addieren oder Subtrahieren eines konstanten Werts auf einen aktuellen Wert für eine bestimmte Anzahl an Takten zu bestimmen. Somit kann immer die gleiche Zeit nach unten und die gleiche Zeit nach oben gezählt werden. Die Verarbeitungseinheit kann eingerichtet sein, um zum Bestimmen des Dreiecksignals die folgenden Schritte auszuführen:

a) Bestimmen einer Startvariable n0, wobei abhängig von der Signalrichtung das Bestimmen ein Addieren oder Subtrahieren einer Schrittweite von einem Startwert umfasst, mit n0 = n0 + (Schrittweite*Signalrichtung), wobei die Schrittweite abhängig von der Soll-Amplitude und der Soll-Frequenz des Ausgangssignals ist,

b) Begrenzen der in a) bestimmten Startvariable;

c) Speichern der begrenzten Startvariable als Dreiecksignal.

Die Verarbeitungseinheit 116 kann eingerichtet sein, nach Schritt c) die Signalrichtung des Ausgangssignals anzupassen, insbesondere erneut.

Die Startvariable n0 kann $\geq 0$ oder $\leq 0$ sein. Die Startvariable kann ein beliebiger positiver oder negativer Integer sein. Die Schrittweite kann den Wert pro Takt des Signalgenerators 112 angeben, der auf die Ist-Amplitude zum Erreichen der Soll-Amplitude zu addieren oder zu subtrahieren ist. Der Takt kann eine Zeiteinheit sein, insbesondere einer internen Uhr des Signalgenerators 112, mit welcher dieser arbeitet. Der Takt kann von mindestens einem Taktgenerator erzeugt werden. Periodische Signale haben vier Sektoren, auch als Signal-Sektoren bezeichnet, auf einem Einheitskreis. Eine Anzahl Takte pro Sektor, welche für die Soll-Frequenz "freq" benötigt wird, kann durch

$$TakteproSektor = \frac{TaktFrequenz}{freq*4}$$

bestimmt werden, wobei "TaktFrequenz" die Taktfrequenz des Signalgenerators ist. Beispielsweise kann der Signalgenerator einen FPGA umfassen. Beispielsweise kann die Taktfrequenz 20 kHz sein. Die Schrittweite kann als

$$Schrittweite = \frac{amp}{TakteProsektor}$$

bestimmt werden, wobei amp eine Amplitude des zu erzeugenden Ausgangssignals ist. Bei Verwendung eines FPGA als Signalgenerator kann die Schrittweite

$$Schrittweite = \frac{amp*256}{TakteProsektor}$$

sein. Der FPGA kann eingerichtet sein, das Ausgangssignal um den Faktor 256 größer zu berechnen. Dies erlaubt Nachkommastellen zu berücksichtigen, welches üblicherweise mit einem FPGA nicht möglich ist. Das Ausgangssignal kann so viel größer berechnet werden, als es eigentlich ist, so dass die Nachkommastellen in die Ganz-Zahlen hineinrutschen. Der Faktor 256 berücksichtigt, dass der FPGA das Ausgangssignal skaliert um 256 berechnet.

Das Begrenzen der Startvariablen kann ein Einschränken auf die Soll-Amplitude, insbesondere auf ein positives Maximum oder ein negatives Minimum umfassen. Die Verarbeitungseinheit 116 kann eingerichtet sein, um in Schritt b) eine skalierte Amplitude n1 mit n1 = amp *nscale zu bestimmen, wobei amp die Soll-Amplitude und nscale ein Skalierungsfaktor ist, und die bestimmte Startvariable auf die skalierte Amplitude zu begrenzen. Bei Verwendung eines FPGAs als Signalgenerator 112 kann nscale beispielsweise 256 sein, welches einem links-shift um 8 Bits entspricht. Bei einem Links-shiften um ein Bit kann der Wert mit dem Faktor 2 multipliziert werden. Diese kann erlauben, Nachkommastellen zu berücksichtigen.

Das System 110 weist mindestens eine Recheneinheit 118 auf. Die Recheneinheit 118 kann mindestens eine Vorrichtung zur Datenverarbeitung umfassen, beispielsweise einen MicroController, einen PC, oder einen Laptop. Wie oben ausgeführt, kann der Signalgenerator 112 mindestens einen FPGA umfassen. FPGAs können ausschließlich Integer-Werte, auch als Ganz-Zahlen bezeichnet, also Zahlen ohne Komma-Werte, berechnen. Eine weitere Schwierigkeit bei einem FPGA kann das Dividieren durch beliebige Zahlen sein, welches viele Ressourcen verbraucht. Viel ressourcenschonender sind Bitshiften und Multiplizieren. Erfindungsgemäß wird deshalb vorgeschlagen, aufwändige Operationen auf eine externe Recheneinheit 118 auszulagern und nur ressourcenschonende Operationen auf der Verarbeitungseinheit des Signalgenerators 112, insbesondere dem FPGA, zu belassen. Parametrisierungsdaten können so von der externen Recheneinheit 118 vorverarbeitet werden und die vorverarbeiteten Informationen an den Signalgenerator übermittelt werden.

Das System 110 weist mindestens ein Kommunikationsinterface 120 auf. Insbesondere kann das Kommunikationsinterface 120 eingerichtet sein zum Übertragen von Informationen von einer Recheneinheit, z.B. einem Computer, um Informationen zu senden oder auszugeben, z.B. auf ein anderes Gerät. Zusätzlich oder alternativ kann das Kommunikationsinterface 120 zum Übertragen von Informationen auf eine Rechenvorrichtung konfiguriert sein, z.B auf einen Computer, um beispielsweise Informationen zu erhalten. Das Kommunikationsinterface 120 kann speziell Mittel zum Übertragen oder Austauschen von Informationen bereitstellen. Insbesondere kann das Kommunikationsinterface 120 eine Datenübertragungsverbindung bereitstellen, z.B. Bluetooth, NFC, induktive Kopplung oder dergleichen. Das Kommunikationsinterface 120 kann beispielsweise eine LAN-Verbindung oder eine SPI-Verbindung bereitstellen. Die mindestens eine Information über die Soll-Amplitude und die Soll-Frequenz des Ausgangssignals ist in das Kommunikationsinterface 120 eingebbar. Die Recheneinheit 118 ist eingerichtet, die eingegebene Information über die Soll-Amplitude und die Soll-Frequenz vorzuverarbeiten und an den Signalgenerator 112 zu übertragen. Die Recheneinheit 118 kann beispielsweise mindestens einen Anwender-Rechner 122 umfassen. Der Anwender kann eine Soll-Frequenz in Hz und eine Soll-Amplitude in Integer Inkrementen in den Anwender-Rechner 122 eingeben. Die Datenvorverarbeitung kann auf dem Anwender-Rechner 122 erfolgen und/oder die Recheneinheit 118 kann eine weitere Recheneinheit aufweisen, welche zu einer Datenvorverarbeitung eingerichtet ist. In Figur 1 sind exemplarisch beide Möglichkeiten gezeigt.

Die Vorverarbeitung der eingegebenen Information kann ein Bestimmen mindestens eines Eingangsparameters für den Signalgenerator 112 umfassen. Der Eingangsparameter kann eine Taktfrequenz pro Signal-Sektor sein. Die Recheneinheit 118 kann eingerichtet sein, die Taktfrequenz pro Signal-Sektor durch

$$TakteproSektor = \frac{TaktFrequenzFPGA}{freq*4}$$

zu bestimmen, wobei TaktFrequenzFPGA eine vorbestimmte Taktfrequenz des Signalgenerators 112 und freq eine Frequenz des zu erzeugenden Ausgangssignals ist. Der Eingangsparameter kann alternativ oder zusätzlich eine Schrittweite sein. Die Recheneinheit kann eingerichtet sein, die Schrittweite

$$Schrittweite = \frac{amp}{TakteProsektor}$$

durch zu bestimmen, wobei amp eine Amplitude des zu erzeugenden Ausgangssignals ist. Alternativ oder zusätzlich kann der Eingangsparameter ein Sinuskoeffizient sein. Insbesondere für den Fall eines FPGAs als Signalgenerator 112 kann die Recheneinheit eingerichtet sein, um den Sinuskoeffizienten durch

$$Sinuskoeffizient = \frac{65535}{amp}$$

zu bestimmen, wobei amp eine Amplitude des zu erzeugenden Ausgangssignals ist.

Das System 110 kann mindestens eine Rechnerumgebung 124 aufweisen. Die Rechnerumgebung 124 kann mindestens einen Mikrocontroller, mindestens ein Field Programmable Gate Array (FPGA) oder mindestens einen Prozessor eines Computers aufweisen. Der Signalgenerator 112 kann zumindest teilweise in der Rechnerumgebung 124 implementiert sein.

Die Verarbeitungseinheit 116 ist eingerichtet, um eine Ist-Amplitude in Abhängigkeit der Signalrichtung für eine Anzahl an Takten mit der Schrittweite zu beaufschlagen. Die Anzahl an Takten ist abhängig von der Soll-Frequenz des Ausgangssignals. Insbesondere kann die Schrittweite aus der Anzahl an Takten bestimmt sein oder werden. Die Verarbeitungseinheit 116 kann eingerichtet sein, um die Schrittweite in Abhängigkeit der Signalrichtung auf die Ist-Amplitude des Ausgangssignals zu addieren oder von der Ist-Amplitude zu subtrahieren. Figur 2 zeigt exemplarisch ein mit einem FPGA erzeugtes Dreieckssignal in Integer Inkrementen als Funktion von FPGA-Takten. Das Dreiecksignal kann aus der Schrittweite und der Signalrichtung durch Ausführen eines Programmcodes erzeugt werden, insbesondere eines Programmcodes in der Programmiersprache C oder ein VHDL-Code. Die Verarbeitungseinheit 116 kann eingerichtet sein, den Programmcode auszuführen.

Beispielsweise kann der Programmcode zum Erzeugen des Dreiecksignals mit einem FPGA folgendermaßen ausgestaltet sein:

$$n = Schrittweite*Signalrichtung; \qquad (1)$$
$$n0 = n0 + n; \qquad (2)$$
$$n1 = amp*256; \qquad (3)$$
$$n0 = lim(n0,n1); \qquad (4)$$
$$dreieck = n0 >>8; \qquad (5)$$
$$n2 = lim\_sts(dreieck, amp); \qquad (6)$$
$$if (n2 !=0)\{ \qquad (7)$$
$$SignalRichtung = SignalRichtung * (-1); \qquad (8)$$
$$\} \qquad (9)$$

In Zeilen (1) und (6) bis (9) wird die Signalrichtung festgelegt. Die Funktion "lim_sts" in Zeile 6 gibt eine 1 zurück, wenn die Variable "dreieck" die positive Soll-Amplitude "amp" nach oben überschreitet, eine -1 wird zurückgegeben, wenn die Variable "dreieck" die negative Soll-Amplitude nach unten unterschreitet und eine 0 wird zurückgegeben, wenn sich der Wert der Variablen "dreieck" innerhalb der negativen und der positiven Soll-Amplitude "amp" befindet. Bei erreichter positiver und bei erreichter negativer Soll-Amplitude kann die Signalrichtung umgekehrt werden. Zeile (2) bewirkt abhängig von der Variablen "SignalRichtung" ein Addieren oder Subtrahieren der Schrittweite. Die Variable "Schrittweite" kann in einer Daten-Vorverarbeitung bestimmt werden. Zeile (3) multipliziert die Soll-Amplitude mit dem Faktor 256, was einem links-shift um 8 bit entspricht. In Zeile (4) wird der Wert der Variablen "n0" auf die maximale Soll-Amplitude, positiv oder negativ, welche mit einem Faktor 256 multipliziert wurde (Variable "n1"), begrenzt. Das Dreiecksignal mit der Soll-Amplitude wird in Zeile (5) erzeugt. Das Dreiecksignal wird aus der Variablen "n0" erzeugt, welche durch den Faktor 256 dividiert wird, was einem rechts-shift um 8 bit entspricht. Bei einem Rechts-shiften um ein Bit kann ein Wert durch den Faktor 2 dividiert werden.

Der Signalgenerator 112 ist weiterhin dazu eingerichtet, mindestens ein Rechtecksignal zu erzeugen. Das Rechtecksignal kann insbesondere gleichzeitig mit dem Dreiecksignal erzeugt werden. Aus dem Dreiecksignal kann zusätzlich das Rechtecksignal erzeugt werden. Wenn das Dreiecksignal nach oben zählt, kann die positive komplette eingestellte Amplitude ausgegeben werden und wenn das Dreiecksignal nach unten zählt, kann die negative komplette Amplitude ausgegeben werden. Die Verarbeitungseinheit 116 ist ingerichtet, um das berechnete Rechtecksignal aus der Signalrichtung und der Soll-Amplitude zu bestimmen. Zum Erzeugen des Rechtecksignals kann die Verarbeitungseinheit 116 eingerichtet sein, einen Programmcode auszuführen. Insbesondere kann zum Erzeugen des Rechtecksignals der Programmcode zusätzlich zu dem oben beschriebenen Programmcode weitere Schritte aufweisen. Beispielsweise kann zum Bestimmen des Rechtecksignals eine weitere Zeile zwischen den Zeilen (5) und (6) eingefügt werden:

$$rechteck = SignalRichtung*amp;$$

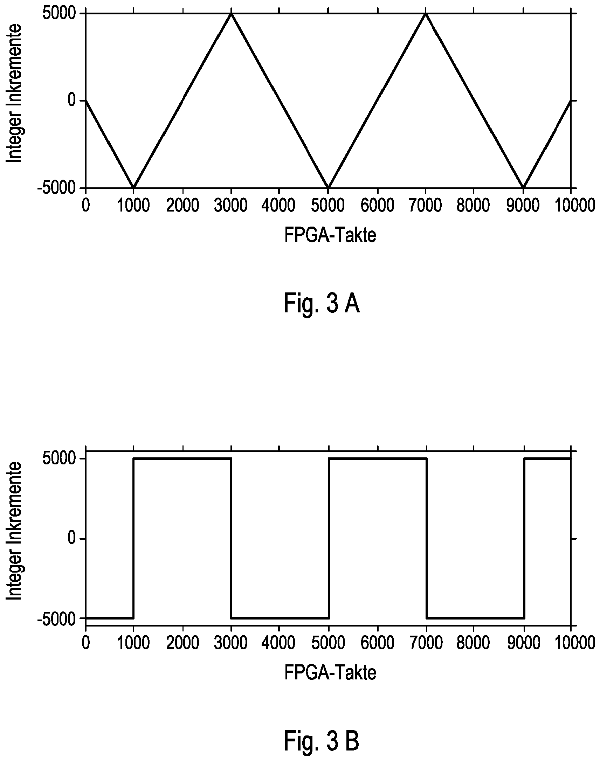

Durch diese zusätzliche Zeile kann beim Zählen in positive Richtung beim Dreiecksignal die maximale positive Amplitude und beim Zählen in negative Richtung beim Dreiecksignal die maximale negative gewünschte Amplitude in der Variable "rechteck" gespeichert werden. Figuren 3A und 3B zeigen den Zusammenhang der Generierung von Dreieck- und Rechteck-Signal und den zeitlichen Verlauf der Signale. Figur 3A zeigt das Dreiecksignal in Integer Inkrementen als Funktion von FPGA-Takten und Figur 3B zeigt das daraus erzeugte Rechtecksignal.

Der Signalgenerator 112 ist weiterhin dazu eingerichtet, mindestens ein Sinus-Signal zu erzeugen. Das Sinus-Signal kann insbesondere gleichzeitig mit dem Dreiecksignal erzeugt werden. Die Berechnung eines echten Sinus-Signals kann sehr aufwändig sein. Insbesondere müsste für jeden einzelnen Wert eine Reihen-Entwicklung ausgeführt werden. Der Signalgenerator 112 kann eingerichtet sein, das Sinus-Signal durch quadratische Funktionen anzunähern. Die Verarbeitungseinheit 116 ist kann eingerichtet, um das Sinus-Signal durch Quadrieren und Skalieren des Dreiecksignals zu bestimmen und zu erzeugen. Zum Erzeugen des Sinus-Signals kann die Verarbeitungseinheit 116 eingerichtet sein, einen Programmcode auszuführen. Insbesondere kann zum Erzeugen des Sinus-Signals der Programmcode zusätzlich zu dem oben beschriebenen Programmcode weitere Schritte aufweisen. Beispielsweise kann zum Bestimmen und Erzeugen des Sinus-Signals mehrere weitere Zeilen zwischen den Zeilen (5) und (6) eingefügt werden:

$$sinus\_1 = dreieck*dreieck;$$

$$sinus\_2 = sinus\_1*SinusKoeffizient;$$

$$sinus\_3 = sinus\_2 >>16;$$

$$sinus\_4 = amp - sinus\_3;$$

$$sinus\_5 = sinus\_4*SignalRichtung;$$

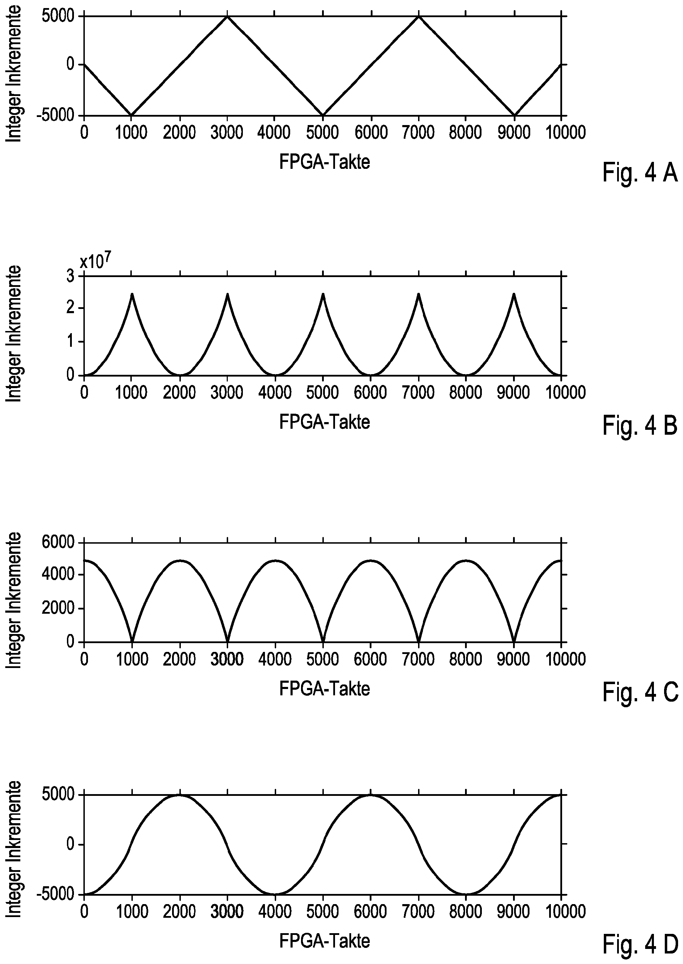

Figur 4A zeigt ein exemplarisches erzeugtes Dreiecksignal, aus welchem ein Sinus-Signal erzeugt wird. Zunächst wird nach diesem Programmcode das Dreiecksignal quadriert, so dass ein Signal mit nach oben geöffneten Parabeln entsteht, siehe Figur 4B. Anschließend wird das Signal durch Multiplikation mit der Variablen "SinusKoeffizient" und Rechts-shiften um 16 bit skaliert. Die Variable "SinusKoeffizient" kann in einer Daten-Vorverarbeitung bestimmt werden. Die Form des Signals kann unverändert bleiben. Der Sinuskoeffizient kann für ein FPGA durch

$$Sinuskoeffzient = \frac{65535}{amp}$$ bestimmt werden, wobei amp die Sollamplitude ist. Die Zahl 65535 =256*256 berücksichtigt das Quadrieren des Dreiecksignals. In der Programmcodezeile für die Bestimmung der Variable "sinus_4" können die Parabeln horizontal gespiegelt werden, siehe Figur 4C. In der letzten Zeile des Programmcodes wird das Sinus-Signal mit Soll-Amplitude und Soll-Frequenz erzeugt, siehe Figur 4D.

Der erfindungsgemäße Signalgenerator 112 erlaubt eine gleichzeitige Erzeugung und Zurverfügungstellung von drei periodischen Ausgangssignalen. Dies kann dadurch erreicht werden, dass die einzelnen Signale aufeinander aufbauend generiert werden. Der Programmcode kann in der Verarbeitungseinheit 116 ausgeführt werden, insbesondere innerhalb des FPGAs. Der Programmcode kann zudem nur Berechnungen umfassen, welche für einen FPGA nicht aufwändig sind, wie Multiplikation, Bitshiften, Addieren und logische Verknüpfungen, so dass der Programmcode ressourcenschonend ist. Für einen FPGA aufwändige Operationen, wie Divisionen und Berechnung von Komma-Zahlen, können auf externen Recheneinheiten berechnet werden, welche diese Operationen mit viel weniger Ressourcen-Aufwand ausführen können. Weiter kann der Signalgenerator 112 ein Sinus-Signal durch quadratische Funktionen nachbilden, so dass viel Rechenleistung gespart werden kann. Ein Erzeugen von Ausgangssignalen ist so auch mit sehr kleinen FPGAs möglich, welche sehr viel günstiger sind als große FPGAs.

Bezugszeichenliste

| | |
|---|---|
| 110 | System |
| 112 | Signalgenerator |
| 114 | Schnittstelle |
| 116 | Verarbeitungseinheit |
| 118 | Recheneinheit |
| 120 | Kommunikationsinterface |
| 122 | Anwender-Rechner |
| 124 | Rechnerumgebung |

**Patentansprüche**

1. Signalgenerator (112), wobei der Signalgenerator (112) eingerichtet ist, mindestens ein periodisches Ausgangssignal zu erzeugen, wobei das Ausgangssignal ein Dreiecksignal umfasst, wobei der Signalgenerator (112) eingerichtet ist, um mindestens einen Eingangsparameter zu empfangen, wobei der Signalgenerator (112) mindestens eine Verarbeitungseinheit (116) aufweist, wobei die Verarbeitungseinheit (116) eingerichtet ist, um eine Signalrichtung des Ausgangssignals zu bestimmen, wobei die Verarbeitungseinheit (116) eingerichtet ist, um eine Schrittweite zu bestimmen, wobei die Verarbeitungseinheit (116) eingerichtet ist, um eine Ist-Amplitude in Abhängigkeit der Signalrichtung für eine Anzahl an Takten mit der Schrittweite zu beaufschlagen, wobei die Anzahl an Takten abhängig von einer Soll-Frequenz des Ausgangssignals ist, **dadurch gekennzeichnet, dass** eine Frequenz und Amplitude des Ausgangssignals einstellbar sind, wobei der Eingangsparameter mindestens eine Information über eine Soll-Amplitude und eine Soll-Frequenz des Ausgangssignals umfasst, wobei der Signalgenerator (112) weiterhin eingerichtet ist mindestens ein Rechtecksignal zu erzeugen, wobei die Verarbeitungseinheit (116) eingerichtet ist, um das Rechtecksignal aus der Signalrichtung und der Soll-Amplitude zu bestimmen, wobei der Signalgenerator (112) weiterhin eingerichtet ist, mindestens ein Sinus-Signal zu erzeugen, wobei die Verarbeitungseinheit (116) eingerichtet ist, um das Sinus-Signal durch Quadrieren und Skalieren des Dreiecksignals zu bestimmen und zu erzeugen.

2. Signalgenerator (112) nach dem vorhergehenden Anspruch, wobei die Verarbeitungseinheit (116) eingerichtet ist, um zum Bestimmen des Dreiecksignals die folgenden Schritte auszuführen:

    a) Bestimmen einer Startvariable n0, wobei abhängig von der Signalrichtung das Bestimmen ein Addieren oder Subtrahieren der Schrittweite von einem Startwert umfasst, mit n0 = n0 + (Schrittweite*Signalrichtung), wobei die Schrittweite abhängig von der Soll-Amplitude und der Soll-Frequenz des Ausgangssignals ist,
    b) Begrenzen der in a) bestimmten Startvariable;
    c) Speichern der begrenzten Startvariable als Dreiecksignal.

3. Signalgenerator (112) nach dem vorhergehenden Anspruch, wobei die Verarbeitungseinheit (116) eingerichtet ist, um in Schritt b) eine skalierte Amplitude n1 mit n1 = amp *nscale zu bestimmen, wobei amp die Soll-Amplitude und nscale ein Skalierungsfaktor ist, und die bestimmte Startvariable auf die skalierte Amplitude zu begrenzen.

4. Signalgenerator (112) nach einem der zwei vorhergehenden Ansprüche, wobei die Verarbeitungseinheit (116) eingerichtet ist, nach Schritt c) die Signalrichtung des Ausgangssignals anzupassen.

5. Signalgenerator (112) nach einem der vorhergehenden Ansprüche, wobei die Verarbeitungseinheit eingerichtet ist, um die Schrittweite in Abhängigkeit der Signalrichtung auf die Ist-Amplitude des Ausgangssignals zu addieren oder von der Ist-Amplitude zu subtrahieren.

6. Signalgenerator (112) nach einem der vorhergehenden Ansprüche, wobei die Verarbeitungseinheit mindestens einen Mikrocontroller, mindestens ein Field Programmable Gate Array (FPGA) oder mindestens einen Prozessor aufweist.

7. System (110) zu einem Erzeugen mindestens eines Ausgangssignals, wobei das System (110) mindestens einen Signalgenerator (112) nach einem der vorhergehenden, einen Signalgenerator betreffenden, Ansprüche umfasst, wobei das System mindestens eine Recheneinheit (118) aufweist, wobei das System mindestens ein Kommunikationsinterface (120) aufweist, wobei mindestens eine Information über eine Soll-Amplitude und eine Soll-Frequenz des Ausgangssignals in das Kommunikationsinterface (120) eingebbar ist, wobei die Recheneinheit (118) eingerichtet ist, die eingegebene Information über die Soll-Amplitude und die Soll-Frequenz vorzuverarbeiten und an den Signalgenerator (112) zu übertragen.

8. System nach dem vorhergehenden Anspruch, wobei die Recheneinheit eine weitere Recheneinheit aufweist, welche zu einer Datenvorverarbeitung eingerichtet ist.

9. Verfahren zum Erzeugen mindestens eines periodischen Ausgangssignals mit mindestens einem Signalgenerator (112) nach einem der vorhergehenden, einen Signalgenerator betreffenden, Ansprüche, wobei das Ausgangssignal ein Dreiecksignal umfasst, wobei das Verfahren die folgenden Schritte umfasst:

   i) Empfangen mindestens eines Eingangsparameters,
   ii) Bestimmen einer Signalrichtung des Ausgangssignals mit mindestens einer Verarbeitungseinheit (116);
   iii) Bestimmen einer Schrittweite mit der Verarbeitungseinheit (116) und Beaufschlagen einer Ist-Amplitude in Abhängigkeit der Signalrichtung für eine Anzahl an Takten mit der Schrittweite, wobei die Anzahl an Takten abhängig von einer Soll-Frequenz des Ausgangssignals ist,

   **dadurch gekennzeichnet, dass** das Verfahren ein Einstellen einer Frequenz und einer Amplitude des Ausgangssignals umfasst, wobei der Eingangsparameter mindestens eine Information über eine Soll-Amplitude und eine Soll-Frequenz des Ausgangssignals umfasst, wobei das Verfahren ein Erzeugen mindestens eines Rechtecksignals umfasst, wobei das Rechtecksignal aus der Signalrichtung und der Soll-Amplitude bestimmt wird, und wobei das Verfahren ein Erzeugen mindestens eines Sinus-Signals umfasst, wobei das Sinus-Signal durch Quadrieren und Skalieren des Dreiecksignals bestimmt und erzeugt wird.

10. Verfahren nach dem vorhergehenden Anspruch, wobei das Verfahren zum Bestimmen des Dreiecksignals weiter die folgenden Schritte aufweist:

   iv) Bestimmen einer Startvariable n0, wobei abhängig von der Signalrichtung das Bestimmen ein Addieren oder Subtrahieren einer Schrittweite von einem Startwert umfasst, mit n0 = n0 + (Schrittweite* Signalrichtung), wobei die Schrittweite abhängig von der Soll-Amplitude und der Soll-Frequenz des Ausgangssignals ist,
   v) Begrenzen der in iv) bestimmten Startvariable;
   vi) Speichern der begrenzten Startvariable als Dreiecksignal.

11. Verfahren nach einem der vorhergehenden, ein Verfahren betreffenden, Ansprüche, wobei das Verfahren mindestens einen Vorverarbeitungsschritt aufweist, in welchem der mindestens eine Eingangsparameter bereitgestellt wird.

12. Verwendung eines Signalgenerators nach einem der vorhergehenden, einen Signalgenerator betreffenden Ansprüche in einer Rechnerumgebung, wobei die Rechnerumgebung einen Mikrocontroller, mindestens einen Integrierten Schaltkreis, insbesondere ein Field Programmable Gate Array (FPGA), oder einen Prozessor eines Computers aufweist.


**Claims**

1. Signal generator (112), wherein the signal generator (112) is configured to generate at least one periodic output signal, wherein the output signal comprises a triangular-waveform signal, wherein the signal generator (112) is configured to receive at least one input parameter, wherein the signal generator (112) has at least one processing unit (116), wherein the processing unit (116) is configured to determine a signal direction of the output signal, wherein the processing unit (116) is configured to determine a step size, wherein the processing unit (116) is configured to apply the step size to an actual amplitude on the basis of the signal direction for a number of clock cycles, wherein the number of clock cycles is dependent on a setpoint frequency of the output signal, **characterized in that** a frequency and an amplitude of the output signal are adjustable, wherein the input parameter comprises at least one piece of information about a setpoint amplitude and a setpoint frequency of the output signal, wherein the signal generator (112) is furthermore configured to generate at least one square-wave signal, wherein the processing unit (116) is configured to determine the square-wave signal from the signal direction and the setpoint amplitude, wherein the signal generator (112) is furthermore configured to generate at least one sine wave signal, wherein the processing unit (116) is configured to determine and generate the sine wave signal by squaring and scaling the triangular-waveform signal.

2. Signal generator (112) according to the preceding claim, wherein the processing unit (116) is configured to determine the triangular-waveform signal by carrying out the following steps:

   a) determining a starting variable n0, wherein, depending on the signal direction, the determining comprises adding or subtracting the step size to or from a starting value, where n0 = n0 + (step size*signal direction), wherein the step size is dependent on the setpoint amplitude and the setpoint frequency of the output signal;
   b) limiting the starting variable determined in a);
   c) storing the limited starting variable as a triangular-waveform signal.

3. Signal generator (112) according to the preceding claim, wherein the processing unit (116) is configured so as, in step b), to determine a scaled amplitude n1, with n1 = amp *nscale, where amp is the setpoint amplitude and nscale is a scaling factor, and to limit the determined starting variable to the scaled amplitude.

4. Signal generator (112) according to either of the two preceding claims, wherein the processing unit (116) is configured to adapt the signal direction of the output signal after step c).

5. Signal generator (112) according to one of the preceding claims, wherein the processing unit is configured to add the step size to the actual amplitude of the output signal or to subtract said step size from the actual amplitude on the basis of the signal direction.

6. Signal generator (112) according to one of the preceding claims, wherein the processing unit has at least one microcontroller, at least one field programmable gate array (FPGA) or at least one processor.

7. System (110) for generating at least one output signal, wherein the system (110) comprises at least one signal generator (112) according to one of the preceding claims relating to a signal generator, wherein the system has at least one computing unit (118), wherein the system has at least one communication interface (120), wherein at least one piece of information about a setpoint amplitude and a setpoint frequency of the output signal is inputtable into the communication interface (120), wherein the computing unit (118) is configured to preprocess the input information about the setpoint amplitude and the setpoint frequency and to transmit said information to the signal generator (112).

8. System according to the preceding claim, wherein the computing unit has a further computing unit, which is configured for a data preprocessing.

9. Method for generating at least one periodic output signal by means of at least one signal generator (112) according to one of the preceding claims relating to a signal generator, wherein the output signal comprises a triangular-waveform signal, wherein the method comprises the following steps:

   i) receiving at least one input parameter;
   ii) determining a signal direction of the output signal by means of at least one processing unit (116);
   iii) determining a step size by means of the processing unit (116) and applying the step size to an actual amplitude on the basis of the signal direction for a number of clock cycles, wherein the number of clock cycles is dependent on a setpoint frequency of the output signal,

   **characterized in that** the method comprises setting a frequency and an amplitude of the output signal, wherein the input parameter comprises at least one piece of information about a setpoint amplitude and a setpoint frequency of the output signal, wherein the method comprises generating at least one square-wave signal, wherein the square-wave signal is determined from the signal direction and the setpoint amplitude, and wherein the method comprises generating at least one sine wave signal, wherein the sine wave signal is determined and generated by squaring and scaling the triangular-waveform signal.

10. Method according to the preceding claim, wherein the method for determining the triangular-waveform signal also has the following steps:

iv) determining a starting variable n0, wherein, depending on the signal direction, the determining comprises adding or subtracting a step size to or from a starting value, where n0 = n0 + (step size*signal direction), wherein the step size is dependent on the setpoint amplitude and the setpoint frequency of the output signal;
v) limiting the starting variable determined in iv);
vi) storing the limited starting variable as a triangular-waveform signal.

11. Method according to one of the preceding claims relating to a method, wherein the method comprises at least one preprocessing step, in which the at least one input parameter is provided.

12. Use of a signal generator according to one of the preceding claims relating to a signal generator in a computer environment, wherein the computer environment has a microcontroller, at least one integrated circuit, in particular a field programmable gate array (FPGA), or a processor of a computer.

**Revendications**

1. Générateur de signal (112), le générateur de signal (112) étant conçu pour générer au moins un signal de sortie périodique, le signal de sortie comprenant un signal triangulaire, le générateur de signal (112) étant conçu pour recevoir au moins un paramètre d'entrée, le générateur de signal (112) comportant au moins une unité de traitement (116), l'unité de traitement (116) étant conçue pour déterminer une direction du signal de sortie, l'unité de traitement (116) étant conçue pour déterminer un incrément, l'unité de traitement (116) étant conçue pour appliquer l'incrément à une amplitude réelle en fonction de la direction du signal pendant un certain nombre de cycles, le nombre de cycles dépendant d'une fréquence cible du signal de sortie, **caractérisé en ce que** la fréquence et l'amplitude du signal de sortie sont réglables, le paramètre d'entrée comprenant au moins une information sur une amplitude cible et une fréquence cible du signal de sortie, le générateur de signal (112) étant en outre conçu pour générer au moins un signal carré, l'unité de traitement (116) étant conçue pour déterminer le signal carré à partir de la direction du signal et de l'amplitude cible, le générateur de signal (112) étant en outre conçu pour générer au moins un signal sinusoïdal, l'unité de traitement (116) étant conçue pour déterminer et générer le signal sinusoïdal par mise au carré et par mise à l'échelle du signal triangulaire.

2. Générateur de signal (112) selon la revendication précédente, l'unité de traitement (116) étant conçue pour effectuer les étapes suivantes afin de déterminer le signal triangulaire :

a) déterminer une variable de départ n0,
la détermination comprenant, en fonction de la direction du signal, l'addition de l'incrément à une valeur de départ ou la soustraction de l'incrément d'une valeur de départ, avec n0 = n0 + (incrément*direction du signal), l'incrément dépendant de l'amplitude cible et de la fréquence cible du signal de sortie ;
b) limiter la variable de départ déterminée en a) ;
c) mémoriser la variable de départ limitée sous forme de signal triangulaire.

3. Générateur de signal (112) selon la revendication précédente, l'unité de traitement (116) étant conçue pour déterminer à l'étape b) une amplitude mise à l'échelle n1, avec n1 = amp*nscale, amp étant l'amplitude cible et nscale étant un facteur d'échelle, et limiter la variable de départ déterminée à l'amplitude mise à l'échelle.

4. Générateur de signal (112) selon l'une des deux revendications précédentes, l'unité de traitement (116) étant conçue pour adapter après l'étape c) la direction du signal de sortie.

5. Générateur de signal (112) selon l'une des revendications précédentes, l'unité de traitement étant conçue pour ajouter l'incrément à l'amplitude réelle du signal de sortie ou pour le soustraire de l'amplitude réelle en fonction de la direction du signal.

**6.** Générateur de signal (112) selon l'une des revendications précédentes, l'unité de traitement comportant au moins un microcontrôleur, au moins un réseau de portes programmable in situ (FPGA) ou au moins un processeur.

**7.** Système (110) destiné à générer au moins un signal de sortie, le système (110) comprenant au moins un générateur de signal (112) selon l'une des revendications précédentes concernant un générateur de signal, le système comportant au moins une unité de calcul (118), le système comportant au moins une interface de communication (120), au moins une information concernant une amplitude cible et une fréquence cible du signal de sortie pouvant être entrée dans l'interface de communication (120), l'unité de calcul (118) étant conçue pour prétraiter l'information entrée concernant l'amplitude cible et la fréquence cible et les transmettre au générateur de signal (112).

**8.** Système selon la revendication précédente, l'unité de calcul comprenant une autre unité de calcul qui est conçue pour le prétraitement de données.

**9.** Procédé de génération d'au moins un signal de sortie périodique à l'aide d'au moins un générateur de signal (112) selon l'une des revendications précédentes concernant un générateur de signal, le signal de sortie comprenant un signal triangulaire, le procédé comprenant les étapes suivantes :

i) recevoir au moins un paramètre d'entrée ;
ii) déterminer une direction du signal de sortie à l'aide d'au moins une unité de traitement (116) ;
iii) déterminer un incrément à l'aide de l'unité de traitement (116) et appliquer l'incrément à une amplitude réelle en fonction de la direction du signal pendant un certain nombre de cycles, le nombre de cycles dépendant d'une fréquence cible du signal de sortie, **caractérisé en ce que** le procédé comprend le réglage de la fréquence et de l'amplitude du signal de sortie, le paramètre d'entrée comprenant au moins une information concernant l'amplitude cible et la fréquence cible du signal de sortie, le procédé comprenant la génération d'au moins un signal carré, le signal carré étant déterminé à partir de la direction du signal et de l'amplitude cible, et le procédé comprenant la génération d'au moins un signal sinusoïdal, le signal sinusoïdal étant déterminé et généré par mise au carré et mise à l'échelle du signal triangulaire.

**10.** Procédé selon la revendication précédente, le procédé de détermination du signal triangulaire comportant en outre les étapes suivantes :

iv) déterminer une variable de départ n0, la détermination comprenant, en fonction de la direction du signal, l'addition d'un incrément à une valeur de départ ou la soustraction d'un incrément d'une valeur de départ, avec n0 = n0 + (incrément*direction du signal), l'incrément dépendant de l'amplitude cible et de la fréquence cible du signal de sortie ;
v) limiter la variable de départ déterminée en iv) ;
vi) mémoriser la variable de départ limitée sous forme de signal triangulaire.

**11.** Procédé selon l'une des revendications précédentes concernant un procédé, le procédé comportant au moins une étape de prétraitement dans laquelle l'au moins un paramètre d'entrée est fourni.

**12.** Utilisation d'un générateur de signal selon l'une des revendications précédentes concernant un générateur de signal dans un environnement informatique, l'environnement informatique comportant un microcontrôleur, au moins un circuit intégré, en particulier un réseau de portes programmable in situ (FPGA), ou un processeur d'un ordinateur.

110

Fig. 1

Fig. 2

Fig. 3 A

Fig. 3 B

Fig. 4 A

Fig. 4 B

Fig. 4 C

Fig. 4 D

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3613505